Europäisches Patentamt

European Patent Office

Office européen des brevets

(19)

(11) Publication number: **0 273 054**
A1

# EUROPEAN PATENT APPLICATION

(12)

published in accordance with Art. 158(3) EPC

(21) Application number: 87902139.2

(51) Int. Cl.⁴: **G 11 C 7/00**, G 11 C 17/00,
G 05 B 19/18

(22) Date of filing: 19.03.87

Data of the international appli-
cation taken as a basis:

(86) International application number:
PCT/JP 87/00170

(87) International publication number:
WO 87/06049 (08.10.87 87/22)

(30) Priority: 28.03.86 JP 70366/86

(43) Date of publication of application: 06.07.88
Bulletin 88/27

(84) Designated Contracting States: DE FR GB

(71) Applicant: FANUC LTD, 3580, Shibokusa Aza-Komanba
Oshino-mura, Minamitsuru-gun Yamanashi 401-05 (JP)

(72) Inventor: KIYA, Nobuyuki, 13-106,
Yokokawa-cho-Jutaku 106, Yokokawa-cho, Hachioji-shi
Tokyo 193 (JP)
Inventor: TORIYAMA, Shuji, 2-4-10, Miyamaedaira
Miyamae-ku, Kawasaki-shi Kanagawa 213 (JP)
Inventor: SAIKI, Yoshiharu, Fanuc-Utsuki-Ryou 386-1,
Ishikawa-cho, Hachioji-shi Tokyo 192 (JP)

(74) Representative: Billington, Lawrence Emlyn et al,
HASELTINE LAKE & CO Hazlitt House 28 Southampton
Buildings Chancery Lane, London WC2A 1AT (GB)

(54) SYSTEM FOR WRITING ROM CASSETTE FOR A PROGRAMMABLE MACHINE CONTROLLER.

(57) In a system for writing ROM cassette for a programmable machine controller, to write a PMC program prepared on a RAM onto the ROM cassette, provision is made of: a reading means which successively reads the data stored in said RAM starting from a final address; a discrimination means which discriminates whether the data read by said reading means is a specific code or not; an address detecting means which detects the address of said RAM which stores the data that was first discriminated by said discrimination means not to be said specific code; and a writing means which successively writes the data stored in said RAM starting from the head address; wherein said writing means is so constituted as to successively write the data onto said ROM cassette from the head address of said RAM through up to the address detected by said address detecting means. The address detected by the address detecting means is an address of the RAM which stores a final portion of the PMC program. Therefore, the writing means writes onto the RAM cassette the data of only a portion where the PMC program is stored.

EP 0 273 054 A1

S P E C I F I C A T I O N

ROM CASSETTE WRITING SYSTEM FOR

A PROGRAMMABLE MACHINE CONTROLLER

TECHNICAL FIELD

The present invention relates to a ROM cassette writing
system for a programmable machine controller.

BACKGROUND ART

It is customary in the prior art to interpose between
a numerical controller and a machine a sequence circuit
composed of a number of relays and actuate required ones of
them by a command from the numerical controller, thereby
causing machine elements to perform an operation corresponding
to the command. However, the provision of such a sequence
circuit inevitably makes the system bulky and expensive
because it calls for a number of relays.

To avoid this, a programmable machine controller has come
into wide use which implements the function of the sequence
circuit through processing under program control. In general,
such a programmable machine controller prestores, in a ROM
cassette composed of an EPROM (an erasable and electrically
reprogrammable ROM), Ladder diagram sequence language program
a program written in PASCAL or a similar computer language
to perform four operations, functional operations, etc., and
a control programs for controlling them, and a microprocessor
performs processing under control of these programs, effecting
sequence control of the machine.

00273054

Incidentally, Ladder diagram sequence language program and the program written in the computer language such as PASCAL (These programs will hereinafter be referred to as a PCM program.) are usually prepared using a RAM panel on which are mounted a ROM having stored therein the above-mentioned control program, a ROM having stored therein an editing program and a RAM for producing the PMC program. The PMC program generated on the RAM and the control program stored in the ROM are transferred serially to a ROM write via an interface circuit such as RS232C, whereby they are stored in the afore-mentioned ROM cassette.

As described above, according to the prior art, the PMC program is created using the RAM mounted on the RAM panel and is serially transferred to the ROM write for storage in the ROM cassette. However, since stored contents at the head address through the final address of the RAM having stored therein the PMC program are all transferred to the ROM writer, the prior art has such a defect as follows: That is to say, since contents of all storage areas of the RAM are always transferred regardless of the quantity of the PMC program, much time is wasted (during which stored contents of the RAM at those addresses where no PMC program is stored are transferred).

SUMMARY OF THE INVENTION

The present invention offers a solution to the above-mentioned problem, and has for its object to eliminate a waste of time in writing the PMC program in the ROM cassette.

To solve the above problem, the system of the present invention by which the PMC program prepared on the RAM is written onto the ROM cassette of a programmable machine controller, comprising:

readout means for successively reading out stored contents of the RAM, starting at the final address;

decision means for deciding whether the data read out by the readout means is a specific code or not;

address detect means for detecting the address of the RAM at which is stored the data which was first decided by the decision means not to be the specific code; and

write means for successibely writing the stored contents of the RAM onto the ROM cassette, starting at the head address;

wherein the write means is so arranged as to succesively write the data onto the ROM cassette from the head address of the RAM to the address detected by the address detect means.

The address detected by the address detect means is an address of the RAM at which the final portion of the PMC program has been stored. Accordingly, the write means writes onto the RAM cassette the data of only the storage areas of the RAM where the PMC program has been stored.

BRIEF DESCRIPTION OF THE DRAWINGS

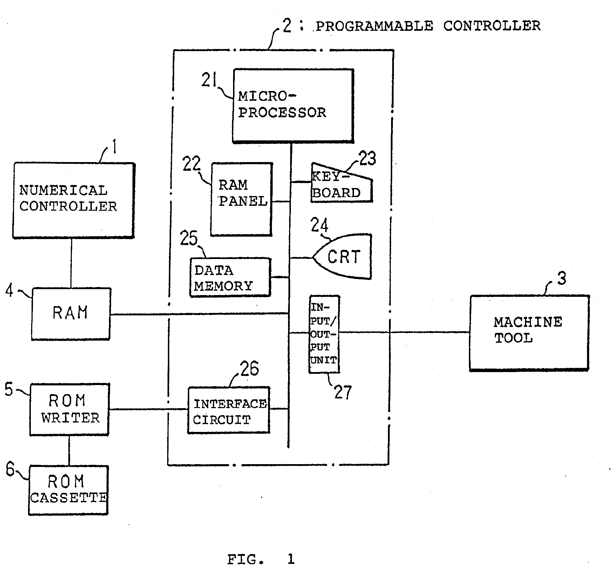

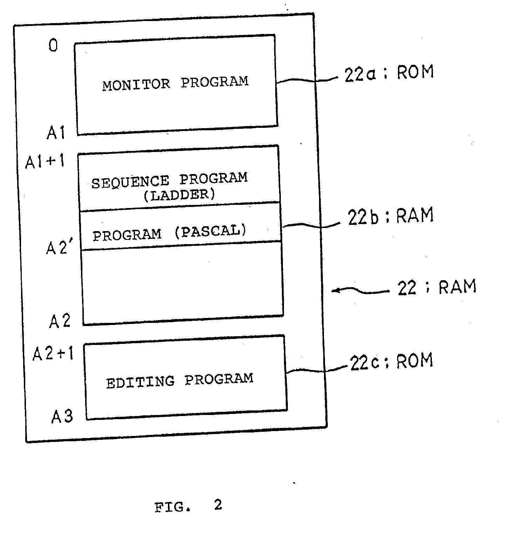

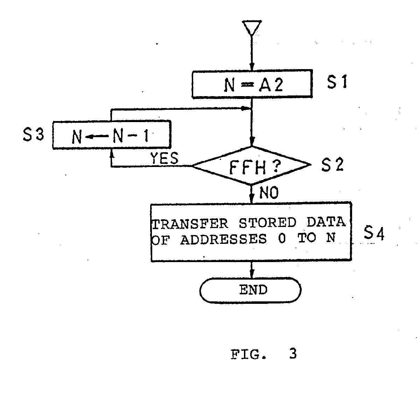

Fig. 1 is a block diagram illustrating an example of an apparatus for embodying the system of the present invention; Fig. 2 is a plan view showing an example of the constitution of a RAM panel 22; and Fig. 3 is a flowchart showing the contents of processing by a microprocessor 21.

BEST MODE FOR CARRYING OUT THE INVENTION

Fig. 1 is a block diagram illustrating an example of an apparatus for embodying the system of the present invention. Reference numeral 1 indicates a numerical controller, 2 a programmable machine controller, 3 a machine tool, 4 a RAM which is shared between the numerical controller 1 and the programmable machine controller 2, 5 a ROM writer, 6 a ROM cassette composed of an EPROM or the like, 21 a microprocessor, 22 a RAM panel, 23 a keyboard, 24 a CRT, 25 a data memory for storing the states of relay contacts, 26 an interface circuit such as RS232C, and 27 an input/output unit. Fig. 2 is a plan view showing the constitution of the RAM panel 22. The RAM panel 22 is composed of a ROM 22a which has stored therein a monitor program, a RAM 22b in which the PMC program is prepared and stored, and a ROM 22c which has stored therein an editing program (a program for displaying the PMC program on the CRT 24 and inserting or removing a program). The ROM 22a is assigned addresses 0 to A1, the RAM 22b addresses (A1+1) to A2, and the ROM 22c addresses (A2+1) to A3.

In the case of preparing Ladder diagram sequence language program and a program written in PASCAL or a similar computer language, the programmer clears the whole area of the RAM 22b with FFH (eight bits all "1's") and then starts the preparation of the PMC program. Upon completion of

002730554

the preparation of the PMC program, the programmer enters a transfer command from the keyboard 23.

When the transfer command is entered, the microprocessor 21 initiates the processing shown in the flowchart of Fig. 3, starting with (step S1) in which the count value N of a counter provided software-wise in the microprocessor is made A2 (the final address of the RAM 22b), followed by (step S2) in which it is decided whether the stored contents at an address N of the RAM 22b are FFH or not. If the result of the decision is YES, then the microprocessor 21 decrements the count value N of the counter by one and (step S3) and returns to the processing of step S2. Where the result of the decision in step S2 is NO, the microprocessor 21 serially transfers the stored contents of the ROM 22a at the addresses 0 to A1 and the stored contents of the RAM 22b at the addresses (A1+1) to N successively to the ROM writer 5 via the interface circuit 26 (step S4), thereby storing the monitor program and the PMC program on the ROM cassette 6.

Now, assuming that the PMC program is stored in the RAM 22b at the addresses (A1+1) to A2', for example, as shown in Fig. 2, it is when the count value N of the counter has reached A2' that the result of the decision in step S2 is NO. Accordingly, only the stored contents of the RAM 22b at the addresses (A1+1) to A2' where the PMC program has been stored are transferred to the ROM writer 5, and the stored contents of the addresses A2' to A2 where the PMC program has

00273054

not been stored are not transferred to the ROM writer 5. This eliminates the waste of time existing in the prior art.

Incidentally, the ROM cassette 6 on which the monitor program and the PMC program have been written as described above is connected to a bus instead of the RAM panel in the case of operating the programmable machine controller 2. Further, while in the above embodiment the FFH is stored in the whole area of the RAM 22b prior to the production of the PMC program, it is also possible, of course, to store a specific code other than the FFH in the whole area of the RAM 22b.

As described above, the system of the present invention by which a PMC program prepared on a RAM is written onto a ROM cassette of a programmable machine controller, comprises: readout means which successively reads out stored data of the RAM, starting at the final address, such as the microprocessor 21; decision means which decides whether the data read out by the readout means is a specific code (FFH in the embodiment) or not, such as the microprocessor 21; address detect means which detects the address of the RAM at which is stored the data decided first by the decision means not to be the specific code, such as the microprocessor 21; and write means which successively writes the stored data of the RAM onto the ROM cassette, starting at the head address of the RAM, such as the microprocessor 21 and the ROM writer 5. The write means sequentially writes onto the ROM cassette the data stored in

00273054

the RAM from the head address to the address detected by the address detect means, and accordingly, writes only the PMC program onto the ROM cassette. Therefore, the present invention possesses the advantage of eliminating the waste of time from which the prior art suffers.

- 8 -

00273054

C L A I M

A ROM cassette writing system for a programmable machine controller in which a PMC program prepared on a RAM is written onto a ROM cassette, comprising:

readout means for successively reading out stored data of the RAM, starting at its final address;

decision means for deciding whether the data read out by the readout means is a specific code or not;

address detect means for detecting the address of the RAM at which is stored the data which was first decided by the decision means not to be the specific code; and

write means for successively writing the stored data of the RAM onto the ROM cassette, starting at the head address of the RAM;

characterized in that the write means successively writes onto the ROM cassette the data stored in the RAM at its head address to the address detected by the address detect means.

2 : PROGRAMMABLE CONTROLLER

FIG. 1

00273054

FIG. 2

FIG. 3

# INTERNATIONAL SEARCH REPORT

0 0 2 7 3 0 5 4

International Application No. **PCT/JP87/00170**

---

**I. CLASSIFICATION OF SUBJECT MATTER** (if several classification symbols apply, indicate all) ³

According to International Patent Classification (IPC) or to both National Classification and IPC

Int.Cl⁴ G11C7/00, 17/00, G05B19/18

---

**II. FIELDS SEARCHED**

| Minimum Documentation Searched ⁴ | |
|---|---|
| Classification System | Classification Symbols |
| IPC | G11C7/00, 17/00, G05B19/18 |

| Documentation Searched other than Minimum Documentation to the Extent that such Documents are Included in the Fields Searched ⁵ |
|---|
| Jitsuyo Shinan Koho                1960 - 1987 |
| Kokai Jitsuyo Shinan Koho          1971 - 1987 |

---

**III. DOCUMENTS CONSIDERED TO BE RELEVANT ¹⁴**

| Category* | Citation of Document, ¹⁶ with indication, where appropriate, of the relevant passages ¹⁷ | Relevant to Claim No. ¹⁸ |
|---|---|---|
| A | JP, A, 58-143496 (Yokogawa Denki Seisakusho Kabushiki Kaisha) 26 August 1983 (26. 08. 83) Page 2, lower left column, lines 2 to 9 (Family: none) | 1 |

---

\* Special categories of cited documents: ¹⁶

"A" document defining the general state of the art which is not considered to be of particular relevance

"E" earlier document but published on or after the international filing date

"L" document which may throw doubts on priority claim(s) or which is cited· to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

---

**IV. CERTIFICATION**

| Date of the Actual Completion of the International Search ² | Date of Mailing of this International Search Report ² |
|---|---|
| April 2, 1987 (02. 04. 87) | April 20, 1987 (20. 04. 87) |
| International Searching Authority ¹ | Signature of Authorized Officer ²⁰ |
| Japanese Patent Office | |

Form PCT/ISA/210 (second sheet) (October 1981)